Europäisches Patentamt

European Patent Office

Office européen des brevets

(19)

(11) Veröffentlichungsnummer : **0 102 613**
**B1**

(12) **EUROPÄISCHE PATENTSCHRIFT**

(45) Veröffentlichungstag der Patentschrift :
06.07.88

(21) Anmeldenummer : 83108552.7

(22) Anmeldetag : 30.08.83

(51) Int. Cl.⁴ : **C 23 C 14/00, B 23 K 31/00**

(54) **Verfahren zum Befestigen von in Scheiben- oder Plattenform vorliegenden Targetmaterialien auf Kühlteller für Aufstäubanlagen.**

(30) Priorität : 07.09.82 DE 3233215

(43) Veröffentlichungstag der Anmeldung :
14.03.84 Patentblatt 84/11

(45) Bekanntmachung des Hinweises auf die Patenterteilung : 06.07.88 Patentblatt 88/27

(84) Benannte Vertragsstaaten :
AT BE CH FR GB IT LI LU NL SE

(56) Entgegenhaltungen :
EP-A- 0 024 355
EP-A- 0 034 408
DE-A- 2 616 270
DE-A- 2 923 174
THE REVIEW OF SCIENTIFIC INSTRUMENTS, Band 44, Nr. 4, April 1973, New York, US C., TERHUNE: "Target bonding (for sputtering)" Seiten 522-523
PATENT ABSTRACTS OF JAPAN, unexamined applications, C Section, Vol. 3, No. 109, 12. September 1979 THE PATENT OFFICE JAPANESE GOVERNMENT Seite 107 C 58
PATENT ABSTRACTS OF JAPAN, unexamined applications, C Field, Vol. 4, No. 151, 23. Oktober 1980 THE PATENT OFFICE JAPANESE GOVERNMENT Seite 95 C 28
PATENT ABSTRACTS OF JAPAN, unexamined applications, C Field, Vol. 4, no. 174, 2. Dezember 1980 THE PATENT OFFICE JAPANESE GOVERNMENT Seite 131 C 33

(73) Patentinhaber : Siemens Aktiengesellschaft Berlin und München
Wittelsbacherplatz 2
D-8000 München 2 (DE)

(72) Erfinder : Keller, Hartmut, Dipl.-Ing.
Feichtetstrasse 2
D-8134 Pöcking (DE)
Erfinder : Sinha Roy, Aroon, Ing. grad.
Tulpenweg 2
D-8067 Petershausen (DE)

## Beschreibung

Die Erfindung bezieht sich auf ein Verfahren zum Befestigen von in Scheiben- oder Plattenform vorliegenden Targetmaterialien auf Kühlteller für Aufstäubanlagen, wobei die Targetscheiben oder -platten mit einer dem Targetmaterial angepaßten Haftschicht und anschließend mittels Plasmaspritzen mit einer Deckschicht, insbesondere einer Kupfer-, Kupfer-Glas oder Silberschicht, versehen werden und wobei die auf diese Weise beschichteten Targetscheiben oder -platten und die Kühlteller getrennt voneinander vorbelotet und anschließend ohne Verwendung eines Flußmittels mit Hilfe des Reflow-Lötens miteinander verlötet werden. Ein derartiges Verfahren ist aus der EP-A-0 024 355 bekannt.

Auf diese Weise können praktisch sämtliche gebräuchlichen Targetmaterialien haftfest und mit gutem Wärmekontakt verbunden werden. Es hat sich jedoch gezeigt, daß die auf diese Weise hergestellte Verbindung nicht absolut blasenfrei und porenfrei ist. Außerdem führten vorhandene Oxidschichten auf den vorbeloteten Flächen zu Leerstellen im Bindequerschnitt.

Ferner ist aus « The Review of Scientific Instruments », Bd. 44, Nr. 4, April 1973, S. 522 bis 523, ein ähnliches Verfahren bekannt, bei welchem jedoch kein Reflow-Löten angewandt wird. Aus Seite 523, rechte Spalte geht hervor, daß Target und Kühlteller auf eine Temperatur unter 150 °C erhitzt werden, daß dann das bei 127 °C schmelzende Lot auf beide Oberflächen aufgebracht wird und anschließend beide Teile zusammengefügt und abgekühlt werden.

Der Erfindung liegt die Aufgabe zugrunde, das aus EP-A-0 024 355 bekannte Verfahren derart weiterzubilden, daß mit Sicherheit vermieden wird, daß die Verbindung Blasen und Poren aufweist. Außerdem sollen eventuell vorhandene Oxidschichten auf den vorbeloteten Teilen mit Sicherheit beseitigt werden.

Die Lösung dieser Aufgabe erfolgt durch folgende Merkmale :

a) die vorbeloteten Targetscheiben oder -platten und die Kühlteller werden zur Entgasung und zum Abbau eventuell noch vorhandener Oxidschichten im Vakuum einer Temperatur ausgesetzt, die oberhalb des Schmelzpunktes des Lotes liegt,

b) vor dem Reflow-Löten wird um den Kühlteller eine Art Rahmen gelegt, der eine den Lötspalt zwischen dem Kühlteller und der auf diesen aufgesetzten Targetscheibe oder -platte umgebende Aussparung aufweist,

c) das anschließende Reflow-Löten findet ebenfalls im Vakuum statt.

Hierdurch wird mit Sicherheit verhindert, daß im Bindequerschnitt Blasen oder Poren entstehen, zumal der Bindequerschnitt durch das Anbringen des Rahmens vollständig mit Lot ausgefüllt werden kann.

Das erfindungsgemäße Verfahren wird anhand der Zeichnung näher erläutert. Es zeigen :

Figur 1   ein Target in Scheibenform,
Figur 2   ein Target in Plattenform,
Figur 3   eine Ansicht von oben auf das Target gemäß Figur 2 mit einem Rahmen und
Figur 4   einen Schnitt nach der Linie IV-IV gemäß Figur 3.

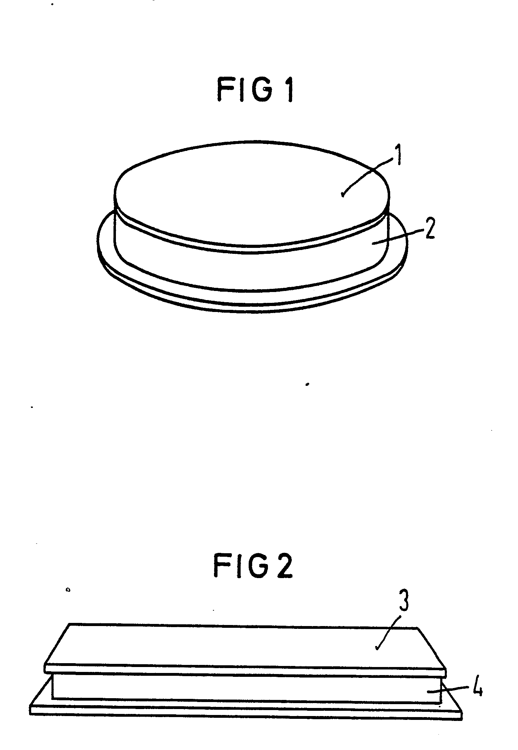

Mit 1 ist eine Targetscheibe aus beliebigem Material bezeichnet, die auf einem Kühlteller 2 durch Löten befestigt ist. Figur 2 zeigt eine Targetplatte 3, die auf einem reckteckförmigen Kühlteller 4 aufgelötet ist.

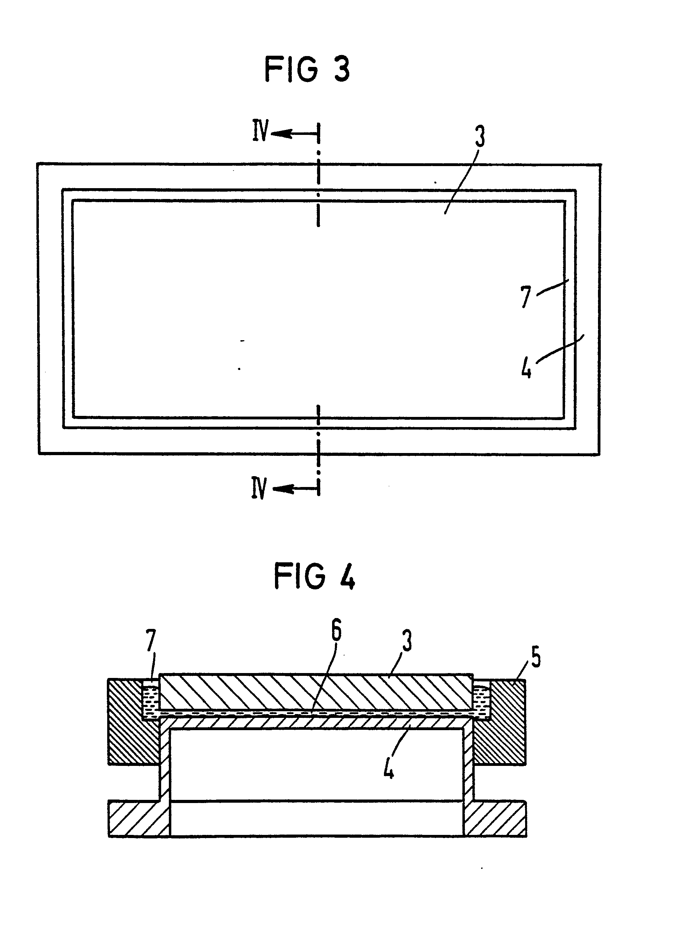

Die Fertigung der in Figur 1 und 2 dargestellten Targets geht in folgender Weise so vor sich, daß auf die Targetscheibe 1 durch Plasmaspritzen eine Haftschicht aufgebracht wird, die dem Targetmaterial entsprechend angepaßt ist. Anschließend wird auf diese Haftschicht ebenfalls durch Plasmaspritzen eine Deckschicht aufgebracht, um die Targetscheibe 1 lötfähig zu machen. Als besonders vorteilhaft hat sich herausgestellt, wenn als Deckschicht eine Kupfer-, Kupfer-Glasoder Silberschicht verwendet wird. Nach dem Aufbringen der Haftschicht und der lötbaren Deckschicht werden die Targetscheibe 1 bzw. Targetplatte 3 sowie der runde bzw. rechteckförmige Kühlteller 2 bzw. 4 unter Verwendung geeigneter Weichlotflußmittel vorbelotet. Zur Entgasung und zum Abbau eventuell noch vorhandener Oxidschichten werden nun die vorbeloteten Targetscheibe 1 bzw. Targetplatte 3 und die Kühlteller 2 und 4 im Vakuum auf eine Temperatur oberhalb des Lotschmelzpunktes gebracht. Zur Vermeidung von Blasen und Poren im Bindequerschnitt wird das Reflow-Löten ebenfalls im Vakuum durchgeführt. Dies wird anhand der Figur 3 und 4 näher erläutert. Vor dem Reflow-Löten wird um den Kühlteller 4 gemäß Figur 4 eine Art Rahmen 5 gelegt, der eine den Lötspalt 6 zwischen dem Kühlteller 4 und der auf diesen aufgesetzten Targetplatte 3 umgebende Aussparung 7 aufweist, so daß eine wannenförmige Nut gebildet wird. Hierbei liegt der Boden der Aussparung knapp unterhalb der Oberfläche des rechteckförmigen Kühltellers 4. Die so zusammengesetzten Teile werden nun im Vakuum mittels Reflow-Löten verbunden. Während des Lötvorgangs fließt das überschüssige Lot aus dem Luftspalt 6 heraus und steigt in der durch die Aussparung 7 gebildete Wanne hoch. Somit bleibt der gesamte Lötspalt bis zur Erstarrung vom Lot bedeckt. Auf diese Weise wird gewährleistet, daß der gesamte Lötspalt im Weichlot ausgefüllt wird. Die Lötung unter Vakuum bewirkt eine weitgehende Blasen- und Porenfreiheit der Verbindung mit optimaler Wärmeleitfähigkeit.

## Patentanspruch

1. Verfahren zum Befestigen von in Scheiben- oder Plattenform vorliegenden Targetmaterialien auf Kühlteller (2, 4) für Aufstäubanlagen, wobei die Targetscheiben (1) oder -platten (3) mit einer dem Targetmaterial angepaßten Haftschicht und anschließend mittels Plasmaspritzen mit einer Deckschicht, insbesondere einer Kupfer-, Kupfer-Glas- oder Silberschicht, versehen werden und wobei die auf diese Weise beschichteten Targetscheiben (1) oder -platten (3) und die Kühlteller (2, 4) getrennt voneinander vorbelotet und anschließend ohne Verwendung eines Flußmittels mit Hilfe des Reflow-Lötens miteinander verlötet werden, gekennzeichnet durch folgende Merkmale :

a) die vorbeloteten Targetscheiben oder -platten (1, 3) und die Kühlteller (2, 4) werden zur Entgasung und zum Abbau eventuell noch vorhandener Oxidschichten im Vakuum einer Temperatur ausgesetzt, die oberhalb des Schmelzpunktes des Lotes liegt,

b) vor dem Reflow-Löten wird um den Kühlteller (2, 4) eine Art Rahmen (5) gelegt, der eine den Lötspalt (6) zwischen dem Kühlteller (2, 4) und der auf diesen aufgesetzten Targetscheibe oder -platte (1, 3) umgebende Aussparung (7) aufweist,

c) das anschließende Reflow-Löten findet eben-falls im Vakuum statt.

## Claim

1. A method of attaching target materials in the form of discs or plates to cooling dishes (2, 4) for sputtering systems, where the target discs (1) or plates (3) are provided with an adhesive layer adapted to the target material and then, by means of plasma spraying, with a covering layer, consisting, in particular, of copper, copper-glass, or silver, and where the target discs (1) or plates (3) coated in this way and the cooling dishes (2, 4) are previously provided with solder separately from one another and are then soldered to one another without the use of a flux, by means of reflow soldering, characterised by the following features :

a) to eliminate gases and to break down any oxide layers which are still present, the target discs or plates (1, 3) and the cooling dishes (2, 4) previously provided with solder, are exposed, in a vacuum, to a temperature above the melting point of the solder,

b) prior to the reflow soldering a kind of frame (5) is positioned around the cooling dish (2, 4), which frame contains a recess (7) which surrounds the soldering gap (6) between the cooling dish (2, 4) and the target disc or plate (1, 3) positioned on the dish,

c) the subsequent reflow soldering is also carried out in a vacuum.

## Revendication

1. Procédé pour fixer des matériaux-cibles se présentant sous la forme de disques ou de plaques et disposés sur un plateau de refroidissement (2, 4) pour des installations de pulvérisation, et selon lequel on dépose sur les disques (1) ou plaques (3) formant cibles une couche adhésive adaptée au matériau-cible et ensuite, au moyen d'une projection de plasma, une couche de revêtement, notamment une couche de cuivre, de cuivre-verre, d'argent, et selon lequel on recouvre préalablement de soudure les disques (1) ou plaques (3) formant cibles et les plateaux de refroidissement (2, 4), séparément les uns des autres, et on les soude ensuite entre eux sans utiliser de flux, au moyen du soudage à reflux, caractérisé par les caractéristiques suivantes :

a) pour le dégazage et la destruction de couches d'oxyde encore éventuellement présentes, on porte sous vide, les disques ou plaques (1, 3) formant cibles préalablement recouvertes de soudure et les plateaux de refroidissement (2, 4), à une température supérieure au point de fusion de la soudure,

b) avant le soudage à reflux, on installe autour du plateau de refroidissement (2, 4) une sorte de cadre (5) qui comporte un évidement (7) entourant la fente de soudage (6) située entre le plateau de refroidissement (2, 4) et le disque ou la plaque (1, 3) formant cible, placée sur ce plateau, et

c) on exécute le soudage ultérieur à reflux, également sous vide.

# FIG 1

# FIG 2

## FIG 3

## FIG 4